Europäisches Patentamt

European Patent Office

Office européen des brevets

(11) Numéro de publication: **0 285 481 B1**

## FASCICULE DE BREVET EUROPEEN

(45) Date de publication de fascicule du brevet: **05.05.93**   (51) Int. Cl.5: **H03H 3/08**, H03H 9/64

(21) Numéro de dépôt: **88400582.8**

(22) Date de dépôt: **11.03.88**

(54) **Procédé de correction d'un dispositif à ondes de surface, notamment pour un filtre dispersif.**

(30) Priorité: **19.03.87 FR 8703838**

(43) Date de publication de la demande:
**05.10.88 Bulletin 88/40**

(45) Mention de la délivrance du brevet:
**05.05.93 Bulletin 93/18**

(84) Etats contractants désignés:
**AT BE CH DE ES FR GB GR IT LI LU NL SE**

(56) Documents cités:
**WO−A−87/03756**
**FR−A− 2 346 899**
**US−A− 3 663 899**
**US−A− 4 460 995**

**TELECOMMUNICATIONS & RADIO ENGINEE−RING, vol. 34/35, no. 5, mai 1980, pages 62−67, Scripta Publishing Co., Silver Spring, Maryland, US; A.E. ZNAMENSKIY et al.: "Features of the construction of narrowband filters for acoustic surface waves"**

(73) Titulaire: **THOMSON−CSF**
**51, Esplanade du Général de Gaulle**
**F−92800 Puteaux(FR)**

(72) Inventeur: **Desbois, Jean**
**THOMSON−CSF SCPI 19, avenue de Messi−ne**
**F−75008 Paris(FR)**

(74) Mandataire: **Desperrier, Jean−Louis**
**THOMSON−CSF, SCPI, B.P. 329, 50, rue Jean−Pierre Timbaud**
**F−92402 Courbevoie Cédex (FR)**

## Description

La présente invention se rapporte aux procédés pour corriger les défauts apparaissant lors de la fabrication des dispositifs à ondes de surface, notamment pour les filtres dispersifs dans lesquels on utilise la réflexion des ondes acoustiques sur des réseaux à pas variables inclinés par rapport à la direction de propagation de ces ondes acoustiques.

Ces filtres sont connus sous le nom générique de RAC, correspondant à l'abréviation de la dénomination anglo-saxonne "Reflective Array Compressors". Le produit bande passante par durée de signal, dit BT, de ces filtres est très important, ce qui en fait l'intérêt.

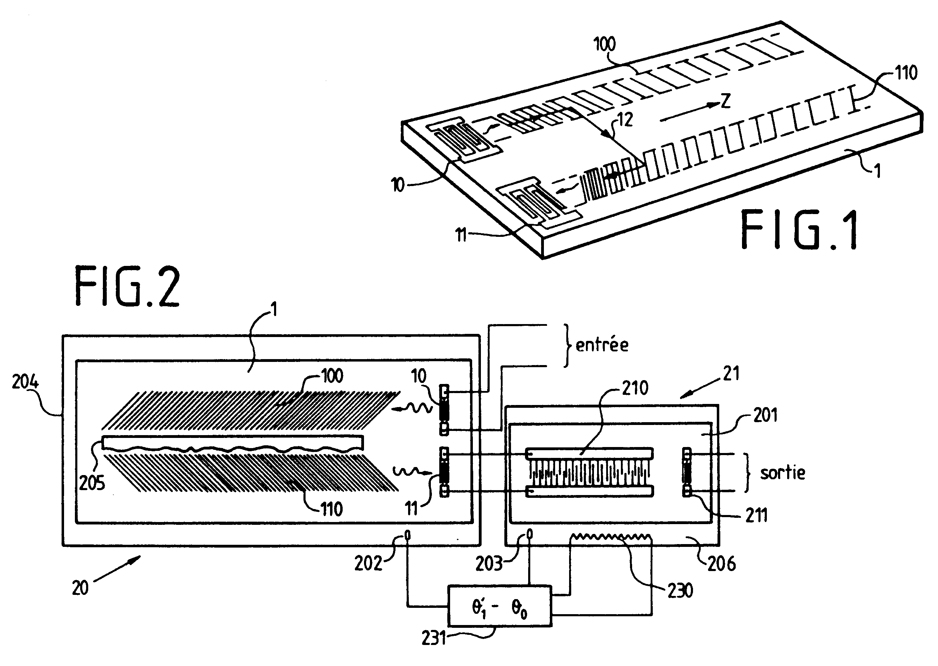

Un RAC correspondant à l'état de l'art est représenté sur la figure 1. Il comporte sur un substrat piézoélectrique 1, un transducteur interdigité d'émission 10 qui, à partir du signal à comprimer, envoie une onde acoustique dans la direction d'un premier réseau réfléchissant 100. Ce réseau comporte une série de discontinuités en forme de traits inclinés sensiblement à 45° par rapport à l'axe de propagation Z de l'onde acoustique. Ces discontinuités, ainsi que le transducteur 10 et le transducteur 11 dont on va parler plus loin, sont formés par des gravures ou des métallisations sur la surface du substrat.

L'onde acoustique est réfléchie par le réseau 100 sensiblement à 90° vers un deuxième réseau 110 identique au premier mais symétrique par rapport à l'axe Z. L'onde acoustique se réfléchit alors sensiblement à 90° sur ce deuxième réseau pour repartir dans la direction opposée à l'axe Z.

Elle est alors recueillie par un transducteur de sortie 11 qu'elle excite pour donner un signal électrique de sortie.

L'espacement des discontinuités dans les deux réseaux réfléchissants est variable en fonction de la distance aux transducteurs d'entrée et de sortie. De cette manière le pouvoir réflecteur est variable avec la fréquence, et selon cette fréquence l'onde acoustique parcourra un trajet tel que 12 dont la longueur, et donc la durée, dépendra de la fréquence.

La fonction de transfert global de ce dispositif correspond au produit des fonctions de transfert des transducteurs d'entrée et de sortie et des réseaux réfléchissants et provoque une compression de l'impulsion appliquée sur le transducteur d'entrée.

Un tel dispositif ne fournit pas directement la réponse en amplitude et en phase exactement souhaitée dans la bande utile, en raison de différents phénomènes parasites comprenant notamment des défauts de construction et des déformations du substrat piézoélectrique lors de sa mise en boîtier.

Il est connu, mais uniquement en ce qui concerne l'erreur de phase, de corriger celle-ci en déposant entre les deux réseaux réfléchissants 100 et 110 un film conducteur de largeur et d'épaisseur variables, pour modifier la vitesse de propagation pour chaque trajet des ondes et donc pour chaque fréquence. Ce procédé ne permet pas toutefois de bien corriger les erreurs variant rapidement avec la fréquence.

Par ailleurs les erreurs introduites par la déformation du substrat piézoélectrique lors de sa mise en boîtier demeurent.

Il est aussi connu de l'article "Features of the construction of Narrowband Filters for Acoustic Surface Waves" publié par A. E. Znamenskiy et autres dans Telecommunications end Radio Engineering, vol. 34/35, N° 5, mai 1980, pages 62-67 de fabriquer des filtres à onde de surface à bande étroite en fabriquant sur un même substrat deux filtres séparés, de préférence identiques, dont la fonction de transfert est donnée par la combinaison, éventuellement le produit, des deux fonctions de transfert individuelles. Il est en effet plus facile de synthétiser deux filtres courts (voire un seul si les deux sont identiques) qu'un seul filtre long. Toutefois cet article n'enseigne rien quant à la correction des erreurs, notamment celles dues à l'encapsulation, qui affectent aussi bien ces deux filtres réalisés simultanément sur le même substrat, que le filtre unique qu'ils remplacent.

Pour corriger au mieux toutes ces erreurs, l'invention propose un procédé de correction d'un filtre dispersif à ondes de surface dans lequel on utilise la réflexion des ondes acoustiques sur des réseaux à pas variables inclinés par rapport à la direction de propagation des ondes acoustiques, ce filtre étant encapsulé dans un boîtier, caractérisé en ce qu'il comprend les étapes suivantes :

- Mesure de la fonction de transfert du filtre dispersif à ondes de surface lorsqu'il est monté de manière définitive dans son boîtier ;

- Synthèse d'un filtre correcteur à ondes de surface dont la fonction de transfert permet la correction notamment des défauts de construction et des déformations du substrat piézoélectrique lors de sa mise en boîtier ;

- Fabrication de ce filtre correcteur ; et

- Mise en série du filtre dispersifs et du filtre correcteur.

D'autres particularités et avantages de l'invention apparaîtront clairement dans la description suivante présentée à titre d'exemple non limitatif en regard des figures annexées qui représentent :

- La figure 1, un RAC selon l'art connu ;

- La figure 2, un RAC corrigé par le procédé selon l'invention ; et

– Les figures 3 et 4, des analyseurs de spectre utilisant de tels RAC.

On a représenté sur la figure 2 un RAC corrigé au moyen du procédé selon l'invention.

Le RAC 20 à corriger comprend, comme celui de la figure 1, sur un substrat 1 un transducteur d'entrée 10, deux réseaux réfléchissants 100 et 110, et un transducteur de sortie 11. Il comprend en outre, de manière connue, une métallisation 205, située entre les réseaux réfléchissants 100 et 110, dont la largeur est variable pour corriger au moins partiellement les erreurs de phase du RAC. Ce RAC est monté de manière définitive dans un boîtier 204 qui est ensuite fermé et qui apporte un certain nombre de perturbations dues aux contraintes mécaniques qu'il exerce sur le substrat 1. Ces contraintes sont essentiellement dues au fait que le RAC est un dispositif de longueur relative‐ ment grande dont la fixation dans le boîtier entraî‐ ne de telles contraintes.

Ce RAC étant ainsi terminé, on mesure sa fonction de transfert $H_M(f)$, tant en amplitude qu'en phase, et ceci dans la gamme de température à l'intérieur de laquelle il est prévu de faire fonction‐ ner le RAC.

Comme on connaît la fonction de transfert sans erreur $H_c(f)$ à obtenir, on calcule par simple division la fonction de transfert H(f) du filtre qui va per‐ mettre de corriger les erreurs du RAC. Ce calcul s'effectue de préférence à la température nominale $\theta_0$ à laquelle on fera travailler le RAC.

On obtient donc : $H(f) = H_c(f)/H_M(f)$

On réalise alors un filtre correcteur à ondes de surface 21 selon les techniques connues. Dans l'exemple représenté, ce filtre 21 comporte sur un substrat 201 un transducteur d'entrée 210 formé de deux peignes interdigités dont les doigts ont une longueur de recouvrement variable et un trans‐ ducteur de sortie non pondéré 211. Le procédé pour obtenir un tel filtre à partir de sa fonction de transfert est connu du brevet français 2 040 881 déposé par la demanderesse le 16 avril 1969. La précision de mise en oeuvre de ce procédé est actuellement telle que les performances du filtre obtenu présentent des erreurs résiduelles très nettement inférieures aux erreurs à corriger dans le RAC.

Selon une variante de réalisation, les deux transducteurs du filtre correcteur ont des doigts de longueurs variables et on dispose entre ces trans‐ ducteurs un coupleur d'ondes acoustiques de sur‐ face.

Dans la réalisation représentée sur la figure 2, le transducteur de sortie du RAC est connecté au transducteur d'entrée pondéré du filtre et le trans‐ ducteur non pondéré de ce dernier constitue le transducteur de sortie de l'ensemble.

Ce type de connexion n'a rien d'obligatoire puisque le produit des fonctions de transfert du RAC et du filtre correcteur est permutatif. On peut donc par exemple placer le filtre correcteur en amont du RAC. On peut aussi utiliser comme transducteur de sortie du filtre correcteur le trans‐ ducteur pondéré.

Le filtre correcteur comprend un boîtier 206 dans lequel on place le substrat 201 comportant les transducteurs. On ferme ensuite ce boîtier.

L'influence des contraintes apportées par le boîtier 206 sur le filtre correcteur est beaucoup plus faible que celle apportée par le boîtier 204 sur le RAC, en raison notamment des dimensions nettement plus importantes du boîtier du RAC par rapport à celles du boîtier du filtre correcteur. L'expérience a montré que les perturbations dues à cette influence au niveau du filtre sont négligea‐ bles devant la correction apportée par ce dernier et que l'utilisation de ce filtre répond bien au but recherché.

Lors de la synthèse du filtre correcteur on se donne une température de fonctionnement du filtre $\theta_1$ et une vitesse des ondes acoustiques à la surface du substrat correspondant à cette tempé‐ rature. On constate après réalisation du filtre que diverses variations inévitables, telles que l'épais‐ seur des métallisations et l'écart dans le rapport largeur/espacement des doigts, entraînent un dé‐ calage homothétique en fréquence de la fonction de transfert du filtre, qui s'analyse essentiellement comme un écart sur la vitesse des ondes acousti‐ ques. Cet écart est la plupart du temps de l'ordre de $10^{-4}$. Si la dégradation des performances constatée est acceptable, on choisit de faire fonc‐ tionner le filtre correcteur à la même température que le RAC, et pour cela on monte les deux boîtiers en contact thermique intime de manière à n'utiliser qu'un seul thermostat pour l'ensemble.

Si par contre la dégradation des performances due à cet écart n'est pas acceptable, on choisit de faire fonctionner le filtre correcteur à une tempé‐ rature différente de la température choisie à la synthèse, afin de compenser l'écart de vitesse. Pour cela on utilise deux thermostats, l'un stabili‐ sant le RAC à la température $\theta_0$ et l'autre stabili‐ sant le filtre correcteur à la température $\theta'_1$ né‐ cessaire pour obtenir les performances souhaitées. Deux sondes thermométriques 202 et 203 per‐ mettent de mesurer respectivement les tempéra‐ tures des boîtiers 204 du RAC et 206 du filtre correcteur. Afin d'éviter de cumuler les erreurs des deux thermostats, on utilise de manière préféren‐ tielle un thermostat commun aux deux boîtiers et des moyens d'ajustement de la température du boîtier 206 par rapport à celle du boîtier 204. Sur la figure, ces moyens d'ajustement sont représen‐ tés par un dispositif de mesure et de contrôle 231, qui mesure la différence de température $\theta'_1 - \theta_1$ et commande l'ajustement de la température $\theta'_1$ par l'intermédiaire d'une résistance électrique 230.

En général un RAC est purement dispersif. Toutefois dans certains cas on a besoin d'appliquer une loi de pondération sur le signal de sortie d'un tel RAC. Selon une variante de réalisation de l'invention, on utilise le filtre correcteur non seulement pour corriger les erreurs du RAC, mais aussi pour appliquer une telle loi de pondération. Si alors $H_p(f)$ est la loi de pondération, on synthétise le filtre de manière à obtenir une fonction de transfert global de celui-ci $H_T(f)$ égale à $H_p(f) \times H(f)$.

Dans le cas où on doit utiliser plusieurs lois de pondération distinctes, on utilise plusieurs filtres correcteurs qui sont commutés sur la sortie du RAC en fonction des besoins.

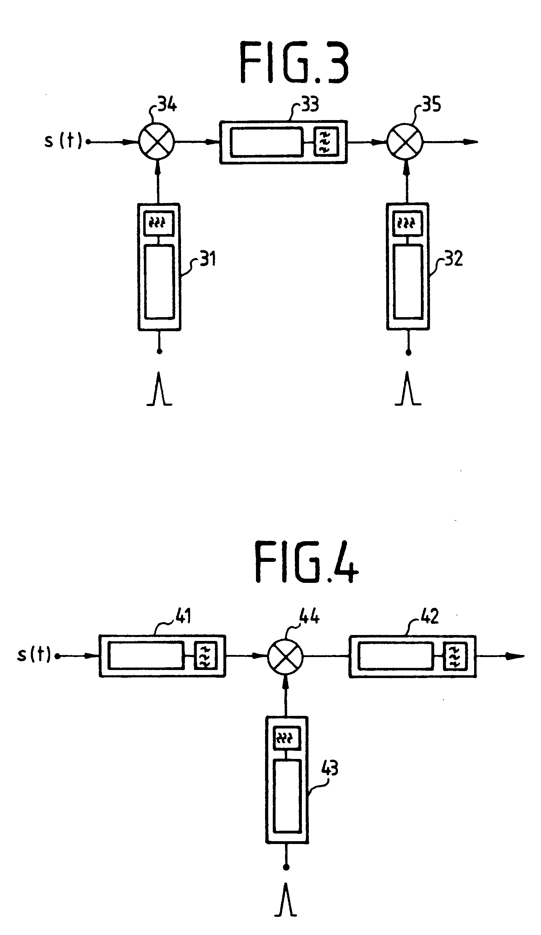

Les RAC ainsi corrigés sont particulièrement utiles pour réaliser des analyses spectrales d'un signal à l'aide de trois lignes dispersives, selon des montages bien connus qui appliquent de manière analogique l'algorithme connu sous le nom anglo-saxon de "Chirp Transform". On utilise soit un montage en $\pi$ représenté sur la figure 3, soit un montage en T représenté sur la figure 4.

Le montage en $\pi$ comprend trois RAC 31 à 33 corrigés selon l'invention. Le RAC 31 alimente un mélangeur 34 qui reçoit également le signal s(t) à analyser. Ce mélangeur est connecté au RAC 33 dont la sortie est elle-même connectée à un autre mélangeur 35 qui reçoit aussi la sortie du RAC 32. Le signal de sortie de ce mélangeur 35 représente le spectre recherché. Les RAC 31 et 32 reçoivent une impulsion brève d'analyse.

Dans le montage en T de la figure 4, le signal s(t) est appliqué à un RAC 41. Un mélangeur 44 reçoit le signal de sortie de ce RAC 41 et d'un RAC 43. Un troisième RAC 42 reçoit le signal de sortie du mélangeur 44 et délivre le spectre désiré. Le RAC 43 reçoit la même impulsion d'analyse que les RAC 31 et 32.

Chacun des trois RAC de ces deux montages est muni d'un filtre correcteur selon l'invention.

Bien qu'elle ait été décrite dans le cadre de la correction d'un RAC, l'invention s'étend à la correction de tous dispositifs à ondes de surface.

## Revendications

1.  Procédé de correction d'un filtre dispersif à ondes de surface dans lequel on utilise la réflexion des ondes acoustiques sur des réseaux à pas variables inclinés par rapport à la direction de propagation des ondes acoustiques, ce filtre étant encapsulé dans un boîtier, caractérisé en ce qu'il comprend les étapes suivantes :

    – Mesure de la fonction de transfert du filtre dispersif à ondes de surface (20) lorsqu'il est monté de manière définitive dans son boîtier (204) ;
    – Synthèse d'un filtre correcteur à ondes de surface (21) dont la fonction de transfert permet la correction notamment des défauts de construction et des déformations du substrat piézoélectrique lors de sa mise en boîtier ;
    – Fabrication de ce filtre correcteur ; et
    – Mise en série du filtre dispersif et du filtre correcteur.

2.  Procédé selon la revendication 1, caractérisé en ce que le produit de la fonction de transfert du filtre dispersif (20) par le produit de la fonction de transfert du filtre correcteur (21) est égal à la fonction de transfert souhaitée.

3.  Procédé selon l'une quelconque des revendications 1 et 2 caractérisé en ce que l'on maintient le filtre dispersif (20) et le filtre correcteur (21) à la même température.

4.  Procédé selon la revendication 3, caractérisé en ce que l'on maintient en contact thermique les boîtiers du filtre dispersif (20) et du filtre correcteur (21) et que l'on utilise un thermostat unique pour les deux.

5.  Procédé selon l'une quelconque des revendications 1 et 2, caractérisé en ce que l'on maintient le boîtier du filtre dispersif (20) à une première température, et que l'on maintient le boîtier du filtre correcteur (21) à une deuxième température différente de la première ; la différence de ces températures permettant d'ajuster la correction du filtre correcteur.

6.  Procédé selon la revendication 5, caractérisé en ce que l'on utilise un thermostat différentiel (231) pour ajuster la deuxième température par rapport à la première.

7.  Procédé selon l'une quelconque des revendications 1 à 6, caractérisé en ce que lors de l'étape de synthèse du filtre correcteur (21) on applique en outre une loi de pondération à la fonction de transfert de ce filtre correcteur.

8.  Procédé selon la revendication 7 caractérisé en ce que l'on synthétise plusieurs filtres correcteurs (21) ayant chacun une loi de pondération distincte.

9.  Analyseur de spectre, caractérisé en ce qu'il utilise au moins un filtre dispersif (31 – 33) corrigé suivant le procédé selon l'une quelconque des revendications 1 à 8.

## Claims

1. Method of correcting a surface wave dispersive filter, in which use is made of the reflection of the acoustic waves on variable-pitch arrays inclined with respect to the direction of propagation of the acoustic waves, this filter being encapsulated in a case, characterised in that it comprises the following steps:
   - measurement of the transfer function of the surface wave dispersive filter (20) when it is mounted permanently in its case (204);
   - synthesis of a surface wave corrector filter (21) whose transfer function allows correction in particular of the constructional defects and of the deformations of the piezoelectric substrate during its encasement;
   - fabrication of this corrector filter; and
   - placement in series of the dispersive filter and of the corrector filter.

2. Method according to Claim 1, characterised in that the product of the transfer function of the dispersive filter (20) times the product of the transfer function of the corrector filter (21) is equal to the desired transfer function.

3. Method according to either one of Claims 1 or 2, characterised in that the dispersive filter (20) and the corrector filter (21) are held at the same temperature.

4. Method according to Claim 3, characterised in that the cases of the dispersive filter (20) and of the corrector filter (21) are held in thermal contact and in that a single thermostat is used for both.

5. Method according to either one of Claims 1 or 2, characterised in that the case of the dispersive filter (20) is held at a first temperature, and in that the case of the corrector filter (21) is held at a second temperature different from the first; the difference in these temperatures allowing adjustment of the correction of the corrector filter.

6. Method according to Claim 5, characterised in that a differential thermostat (231) is used to adjust the second temperature with respect to the first.

7. Method according to any one of Claims 1 to 6, characterised in that during the step of synthesising the corrector filter (21), a weighting law is furthermore applied to the transfer function of this corrector filter.

8. Method according to Claim 7, characterised in that several corrector filters (21) are synthesised, each having a distinct weighting law.

9. Spectral analyser, characterised in that it uses at least one dispersive filter (31 – 33) corrected in accordance with the method according to any one of Claims 1 to 8.

## Patentansprüche

1. Verfahren zur Korrektur eines dispersiven Oberflächenwellenfilters, in dem die Reflexion der akustischen Wellen an Gittern mit variabler Gitterkonstante verwendet wird, die bezüglich der Fortpflanzungsrichtung der akustischen Wellen geneigt sind, wobei dieses Filter in ein Gehäuse eingekapselt ist, dadurch gekennzeichnet, daß es folgende Verfahrensschritte aufweist:
   - Messung der Transferfunktion des dispersiven Oberflächenwellenfilters (20) nach dessen definitiver Montage in seinem Gehäuse (204),
   - Synthese eines Oberflächenwellen-Korrekturfilters (21), dessen Transferfunktion die Korrektur insbesondere der konstruktiv bedingten und durch die Verformungen des piezoelektrischen Substrats beim Einsetzen in das Gehäuse bedingten Fehler erlaubt,
   - Herstellung dieses Korrekturfilters,
   - und Serienschaltung des dispersiven Filters und des Korrekturfilters.

2. Verfahren nach Anspruch 1, dadurch gekennzeichnet, daß das Produkt der Transferfunktion des dispersiven Filters (20) mit der Transferfunktion des Korrekturfilters (21) der gewünschten Transferfunktion gleich ist.

3. Verfahren nach einem beliebigen der Ansprüche 1 und 2, dadurch gekennzeichnet, daß das dispersive Filter (20) und das Korrekturfilter (21) auf gleicher Temperatur gehalten werden.

4. Verfahren nach Anspruch 3, dadurch gekennzeichnet, daß die Gehäuse des dispersiven Filters (20) und des Korrekturfilters (21) in thermischen Kontakt gehalten werden und daß ein gemeinsamer Thermostat für beide verwendet wird.

5. Verfahren nach einem beliebigen der Ansprüche 1 und 2, dadurch gekennzeichnet, daß man das Gehäuse des dispersiven Filters (20) auf einer ersten Temperatur hält und daß man das Gehäuse des Korrekturfilters (21) auf einer zweiten, davon unterschiedlichen Temperatur hält, wobei die Differenz dieser Temperaturen die Justierung der Korrektur des Korrekturfilters ermöglicht.

6. Verfahren nach Anspruch 5, dadurch gekennzeichnet, daß man einen Differentialthermostat (231) zur Justierung der zweiten Temperatur bezüglich der ersten verwendet.

7. Verfahren nach einem beliebigen der Ansprüche 1 bis 6, dadurch gekennzeichnet, daß bei der Synthese des Korrekturfilters (21) außerdem ein Gewichtungsgesetz auf die Transferfunktion dieses Korrekturfilters angewandt wird.

8. Verfahren nach Anspruch 7, dadurch gekennzeichnet, daß man mehrere Korrekturfilter (21) mit je einem eigenen Gewichtungsgesetz synthetisiert.

9. Spektralanalysator, dadurch gekennzeichnet, daß er mindestens ein dispersives Filter (31 bis 33 ) verwendet, das nach dem Verfahren gemäß einem der Ansprüche 1 bis 8 korrigiert ist.

EP 0 285 481 B1

**FIG.1**

**FIG.2**

$\theta_1' - \theta_0$

231

230

206

211

sortie

201

210

21

11

110

205

100

10

entrée

202

203

20

204

7

# FIG.3

s(t)

# FIG.4

s(t)